# EUROPÄISCHE PATENTSCHRIFT

(11) **EP 1 525 660 B1**
(45) Veröffentlichungstag und Bekanntmachung des Hinweises auf die Patenterteilung: **25.03.2009**
(21) Anmeldenummer: 03783968.5
(22) Anmeldetag: 21.05.2003
(51) Int. Cl.: H03K 17/00, H02J 3/00

(54) **SCHALTUNGSANORDNUNG ZUR STEUERUNG VON ZWEI UNABHÄNGIGEN MIT EINER GLEICHGERICHTETEN WECHSELSPANNUNG BETREIBBAREN LASTEN**
CIRCUIT ARRANGEMENT FOR CONTROLLING TWO INDEPENDENT LOAD RESISTORS THAT CAN BE OPERATED WITH A RECTIFIED ALTERNATING CURRENT VOLTAGE
CIRCUIT DE REGULATION DE DEUX CHARGES INDEPENDANTES FONCTIONNANT A L'AIDE D'UNE TENSION ALTERNATIVE REDRESSEE

(30) Priorität: 25.07.2002 DE 10233876
(43) Veröffentlichungstag der Anmeldung: 27.04.2005
(73) Patentinhaber: austriamicrosystems AG, 8141 Unterpremstätten (AT)
(72) Erfinder: THEILER, Helmut, A-8501 Lieboch (AT)
(74) Vertreter: Epping - Hermann - Fischer
(86) Internationale Anmeldenummer: PCT/EP2003/005328
(87) Internationale Veröffentlichungsnummer: WO 2004/015865

(56) Entgegenhaltungen:
- EP-A- 0 117 198
- EP-A- 0 515 961
- DE-A- 3 813 538
- US-A- 4 777 379

## Beschreibung

Die Erfindung betrifft eine Schaltungsanordnung zur Steuerung von zwei unabhängigen, mit einer gleichgerichteten Wechselspannung betreibbaren Lasten.

Viele elektrische Geräte beinhalten zwei Lasten, die getrennt voneinander ansteuerbar sein müssen. Ein Beispiel für ein solches Gerät ist ein Luftbefeuchter, der gleichzeitig eine Lampe als Nachtbeleuchtung besitzt. Der Luftbefeuchter wird dabei von einer Zeitschaltuhr gesteuert, so daß immer während einer bestimmten Zeit, in der beispielsweise das Betriebsgeräusch nicht stört, die entsprechenden Pumpen und Ventilatoren eingeschaltet werden. Zur Ansteuerung der Nachtbeleuchtung gelten andere Regelungen. Diese wird beispielsweise in Abhängigkeit des Meßwertes eines Lichtsensors gesteuert, so daß die Nachtbeleuchtung nur brennt, wenn die Umgebung dunkel ist.

Zur Lösung dieser Aufgabe wird in elektrischen Geräten eine Schaltungsanordnung zur Steuerung von zwei unabhängigen, mit einer gleichgerichteten Wechselspannung betreibbaren Lasten eingesetzt. Zwar sind elektrische Lasten wie zum Beispiel Lampen auch mit einer Wechselspannung betreibbar, jedoch ist es für das Schalten der Lasten von Vorteil, wenn es sich um eine Gleichspannung handelt. Diese kann mit einem MOSFET oder einem Bipolartransistor geschaltet werden, während die Steuerung von wechselspannungsbetriebenen Lasten wesentlich aufwendiger ausfällt, da sowohl die positive als auch die negative Halbwelle berücksichtigt werden müssen. Die gesteuerten Lasten werden in der Regel mit der üblichen Netzspannung betrieben, da eine niedrigere Betriebsspannung zum einen einen teuren Transformator erforderlich machen würde, zum anderen wäre der auftretende Strom wesentlich höher, so daß die Kabelquerschnitte größer ausgelegt werden müssen und somit die gesamte Schaltungsanordnung und damit das Gerät teurer wird. Bei einer Netzspannung von 230 Volt ergibt sich für die gleichgerichtete Spannung eine Spitzenspannung von 340 Volt. Dementsprechend müssen für die verwendeten Transistoren zum Schalten der Lasten Typen ausgewählt werden, die diese hohe Spannung schalten können. Bei Schaltungen nach dem Stand der Technik sind also zwei hochspannungsgeeignete Halbleiterschalter zu verwenden, die im Vergleich zur Ansteuerschaltung sehr teuer sind und somit einen hohen Anteil an den gesamten Herstellungskosten besitzen. Der hohe Preis für die verwendeten Hochspannungshalbleiterschalter trägt deswegen auch einen großen Anteil an den Kosten für das gesamte Gerät, da es sich bei elektrischen Geräten der beschriebenen Art um einfach konstruierte Geräte handelt, die zu einem sehr günstigen Preis angeboten werden.

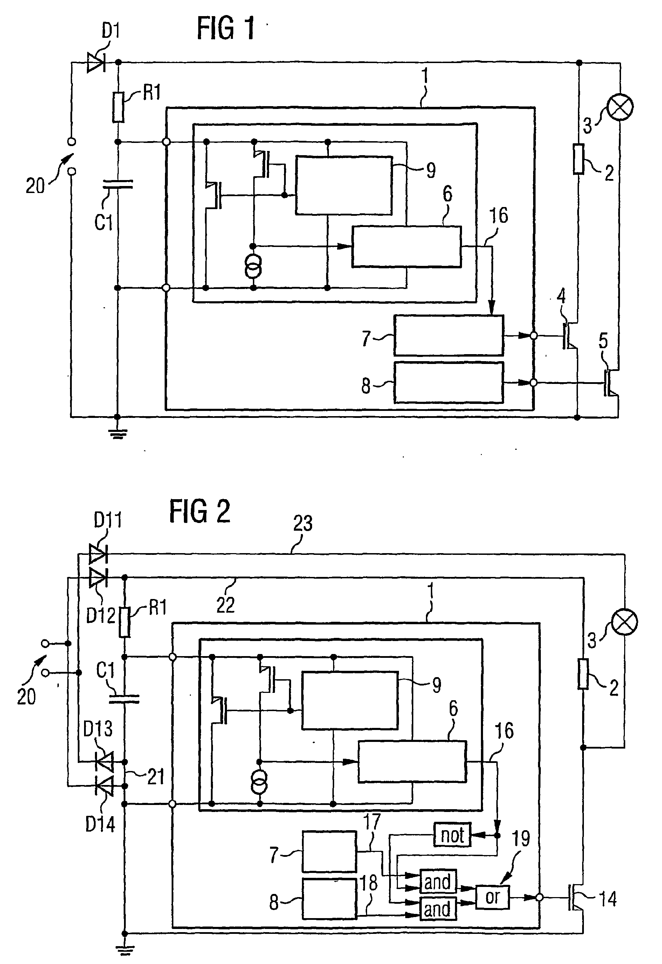

Eine prinzipiell bekannte Schaltung aus dem Stand der Technik ist in der Figur 1 dargestellt, die im Rahmen der Figurenbeschreibung näher erläutert werden wird.

Da die hochspannungsgeeigneten Halbleiterschalter einen großen Anteil an den gesamten Herstellungskosten tragen, ist es wünschenswert, für die Steuerung von zwei Lasten nicht zwei Halbleiterschalter verwenden zu müssen.

Aufgabe der Erfindung ist es daher, eine Schaltungsanordnung anzugeben, mit der zwei Lasten unabhängig voneinander geschaltet werden können, ohne daß dazu die Verwendung von zwei Halbleiterschaltern zur Schaltung der Lasten erforderlich ist.

Diese Aufgabe wird erfindungsgemäß durch eine Schaltungsanordnung zur Steuerung von zwei unabhängigen, mit einer gleichgerichteten Wechselspannung betreibbaren Lasten gelöst mit einer Steuereinheit zur Erzeugung eines Ansteuersignals für einen Halbleiterschalter, durch den beide Lasten steuerbar sind in Abhängigkeit von je einem Steuersignal pro Last, wobei die Steuereinheit eine Phasenerkennungsvorrichtung aufweist, durch die eine positive oder negative Phase der Wechselspannung erkennbar ist und die ein die momentane Phase beschreibendes Ausgangssignal bereitstellt, und wobei die Steuereinheit eine Logikeinheit aufweist zur Verknüpfung der Steuersignale mit dem Ausgangssignal der Phasenerkennungsvorrichtung zur Bestimmung des Ansteuersignals.

Der Grundgedanke der vorliegenden Erfindung besteht in der Ausnutzung der Tatsache, daß es genügt, eine Last mit nur einer Halbwelle der am Eingang anliegenden Wechselspannung zu versorgen. Während bei einer Schaltungsanordnung aus dem Stand der Technik für beide Lasten die gleiche Halbwelle verwendet wird, ist bei der erfindungsgemäßen Schaltungsanordnung vorgesehen, für jede Last eine andere Halbwelle zu verwenden. Ein elektrisches Gerät kann dann vorteilhaft so gestaltet werden, daß man mit nur einem Halbleiterschalter auskommt.

Die erfindungsgemäße Schaltungsanordnung wird in einem elektrischen Gerät deswegen in Verbindung mit einem Gleichrichter eingesetzt, der in einer offenen Brückenschaltung ausgeführt ist. Während ein Gleichrichterausgang gemeinsam genutzt wird, werden die beiden anderen Gleichrichterausgänge jeweils auf eine Last geführt.

Vorteilhaft ist eine Schaltungsanordnung nach der Erfindung so ausgeführt, daß zur Erzeugung zumindest eines Steuersignals eine Zeitsteuerung vorgesehen ist, während für das andere Steuersignal eine Sensorschaltung vorgesehen werden kann. Beide Ansteuerungsvarianten, also nach Zeit oder in Abhängigkeit eines Sensormeßwertes, können auch miteinander kombiniert werden.

Die Erfindung wird nachfolgend anhand von Ausführungsbeispielen näher erläutert. Es zeigt:
- Figur 1: eine Schaltungsanordnung nach dem Stand der Technik in einem elektrischen Gerät,
- Figur 2: eine erfindungsgemäße Schaltungsanordnung und
- Figuren 3 und 4: zwei Varianten zur Realisierung einer erfindungsgemäßen Schaltungsanordnung.

Die Figur 1 zeigt eine Schaltungsanordnung 1 zur Steuerung von zwei unabhängigen, mit einer gleichgerichteten Wechselspannung betreibbaren Lasten, wie sie aus dem Stand der Technik bekannt ist. Dabei ist eine Gleichrichterdiode D1 mit einem Wechselspannungseingang 20 verbunden. Die von der Diode D1 durchgelassenen Halbwellen steht zum Einen zur Spannungsversorgung der Schaltungsanordnung 1 als auch der Lasten 2 und 3 zur Verfügung. Als Lasten 2 und 3 ist beispielsweise ein Heizwiderstand 2 und eine Lampe 3 vorgesehen. Der zweite Anschluß des Wechselspannungseingangs 20 ist mit Masse verbunden. Die Laststromkreise schließen sich über zwei Halbleiterschalter 4 und 5, die die Lasten 2 und 3 jeweils mit Massen verbinden. Als Halbleiterschalter sind in dieser Ausführung einer Schaltungsanordnung nach dem Stand der Technik N-Kanal-MOSFETs vorgesehen.

Zu Glättung der durch den Einweggleichrichter D1 auf sehr einfache Weise gleichgerichteten Spannung ist ein Widerstand R1 und ein Kondensator C1 vorgesehen, die für die Spannungsversorgung der Schaltungsanordnung 1 eingesetzt sind. Die Schaltungsanordnung 1 weist eine Kontrollvorrichtung 9 und eine Phasenerkennungsvorrichtung 6 auf. Die Phasenerkennungsvorrichtung 6 erkennt auf Grund der Welligkeit der Eingangsspannung, ob von der Diode D1 gerade eine positive Halbwelle durchgelassen wird, oder ob gerade eine negative Halbwelle anliegt. Die Phasenerkennungsvorrichtung 6 stellt an ihrem Ausgang ein Ausgangssignal 16 bereit, das gleichzeitig eine Zeitsteuerung 7 und eine Sensorschaltung 8 triggert. Diese steuern daraufhin die beiden Halbleiterschalter 4 und 5 an.

Wenn also beispielsweise die Sensorschaltung 8 feststellt, daß die Lampe 3 eingeschaltet werden müßte, steuert sie bei Anlegen des Ausgangssignals 16 der Phasenerkennungsvorrichtung 6 den Halbleiterschalter 5 an, damit dieser niederohmig wird und der die Lampe 3 beinhaltende Stromkreis geschlossen wird.

In gleicher Weise steuert die Zeitsteuerung 7 den Halbleiterschalter 4 an, damit dieser den Stromkreis schließt, der den Heizwiderstand 2 beinhaltet.

Die Figur 2 zeigt eine erfindungsgemäße Schaltung zur Steuerung von zwei unabhängigen, mit einer gleichgerichteten Wechselspannung betreibbaren Lasten 2 und 3. Der Bestandteil der Schaltungsanordnung, der die Kontrolleinheit 9 und die Phasenerkennungsvorrichtung 6 beinhaltet, ähnelt dem von Figur 1. Am Ausgang der Phasenerkennungsvorrichtung 6 wird ein Ausgangssignal 16 bereitgestellt, anhand dessen erkennbar ist, daß momentan die positive Phase der Wechselspannung anliegt. Eine Zeitsteuerung 7 erzeugt ein Steuersignal 17, das angibt, ob der Heizwiderstand 2 eingeschaltet sein soll. Eine Sensorschaltung 8 erzeugt ein Steuersignal, das angibt, ob die Lampe 3 eingeschaltet sein soll. Erfindungsgemäß werden diese Steuersignale mit dem Ausgangssignal 16 der Phasenerkennungsvorrichtung 6 verknüpft. Dabei wird jedes Steuersignal 17 und 18 mit dem Ausgangssignal 16 verknüpft, wobei das Steuersignal 18 mit dem invertierten Ausgangssignal 16 in einem UND-Glied verknüpft wird, während das Steuersignal 16 dem UND-Glied, das zur Verknüpfung mit dem Steuersignal 17 vorgesehen ist, direkt zugeleitet wird. Die Ausgänge der beiden UND-Glieder werden in einer ODER-Verknüpfung miteinander verbunden und das Verknüpfungsergebnis zur Ansteuerung eines Halbleiterschalters 14 bereitgestellt.

Im vorliegenden Fall wird angenommen, daß das Vorliegen einer positiven Halbwelle mit einer logischen "1" signalisiert wird, und daß der Halbleiterschalter 14, im vorliegenden Ausführungsbeispiel ein N-Kanal-MOSFET, durchgeschaltet werden soll, wenn die Zeitsteuerung 7 ebenfalls eine "1" ausgibt. Durch die Invertierung erhält das andere UND-Glied bei einer positiven Halbwelle eine logische "0". Bei einer positiven Halbwelle ist es daher unmöglich, am Ausgang des mit der Sensoreinheit 8 verbundenen UND-Gliedes eine "1" zu erhalten, auch wenn das Steuersignal 18 eine logische "1" signalisiert. Bei einer negativen Halbwelle sind die Verhältnisse umgekehrt.

Mit anderen Worten bewirkt die Logikeinheit 19, die durch die beschriebenen Logikglieder gebildet wird, daß die Vorgabe der Zeitsteuerung 7 während der positiven Halbwelle berücksichtigt wird, während die Vorgabe der Sensorschaltung 8 während der negativen Halbleiter berücksichtigt wird.

Um sicherzustellen, daß der Schaltzustand des MOSFET 4 nur eine der beiden Lasten 2 und 3 betrifft, ist ein Gleichrichter in einer offenen Brückenschaltung ausgeführt. Der Gleichrichter, der durch die Dioden D11 bis D14 gebildet wird, ist so geschaltet, daß die negativen Halbwellen zu einem gemeinsamen Gleichspannungsausgang 21 durchgelassen werden. Der negative Gleichspannungsausgang 21 ist mit Masse verbunden. Der positive Gleichspannungsausgang 22 und 23 ist zweigeteilt, d. h. die Katoden der Dioden D 11 und D12 sind nicht miteinander verbunden. Statt dessen ist die Katode der Diode D11 mit der Last 3, also der Lampe verbunden, während die Katode der Diode D12 mit dem Heizwiderstand 2 verbunden ist.

Der Spannungsabgriff für die Schaltungsanordnung 11 und damit für die Phasenerkennungsvorrichtung 6 liegt an der Kathode der Diode D12, es wird also die Phase am Gleichspannungsausgang 22 für die Detektion verwendet. Die Detektion einer positiven Halbwelle bedeutet daher, daß während dieser Halbwelle nur durch den Heizwiderstand 2 ein Strom fließt. Das Steuersignal der Zeitschaltung 7, das nur während einer positiven Halbleiter berücksichtigt werden kann, wie oben beschrieben, wirkt sich daher nur auf den Heizwiderstand 2 aus, da durch die Lampe 3 ohnehin kein Strom fließen kann. Bei der negativen Halbwelle verhält es sich umgekehrt, woraus folgt, daß die Sensorschaltung 8 nur für den Schaltzustand der Lampe 3 eine Auswirkung haben kann.

Durch die erfindungsgemäße Schaltungsanordnung ist somit ein elektrisches Gerät realisierbar, welches zur Steuerung von zwei unabhängigen Lasten nur einen MOSFET 14 benötigt. Statt eines MOSFETs 14 kann selbstverständlich auch ein Bipolartransistor verwendet werden, wobei sich nur die ohnehin nicht im Detail gezeigte Ansteuerschaltung zur Ansteuerung des Transistors 14 ändert.

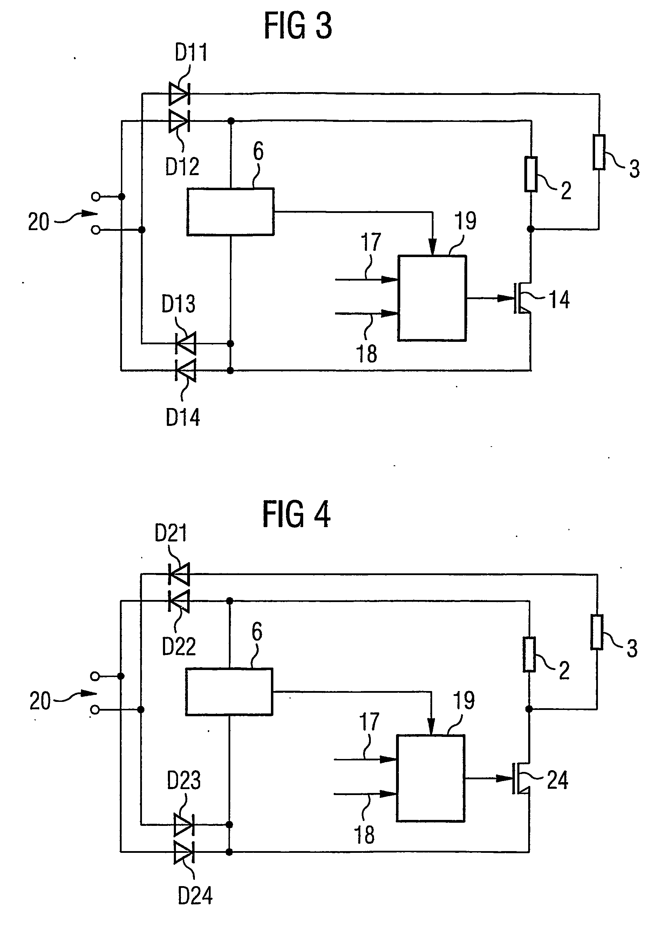

Das Prinzip der Schaltung von Figur 2 ist in Figur 3 nochmals in einer einfachen, schematischen Darstellung gezeigt, wobei als Halbleiterschalter 14 wiederum ein N-Kanal-MOSFET Verwendung findet. In der Figur 4 wird statt eines N-Kanal-MOSFETs 14 ein P-Kanal-MOSFET 24 eingesetzt. Als weitere Änderung müssen die Dioden in umgekehrter Polung geschaltet werden. Im Vergleich zur Schaltung von Figur 3 ist die Diode 21 umgekehrt gepolt im Vergleich zur Diode D11. Gleiches gilt für die anderen Dioden D22, D23 und D24.

Die Erfindung ist nicht auf die in Figur 2 dargestellte Ausführung der Logikeinheit 19 beschränkt, sondern es sind auch eine Vielzahl von Variationen dieser Schaltung denkbar. In den Figuren 3 und 4 ist die Logikeinheit 19 als schematische Multiplexer-Schaltung dargestellt, so daß auch sämtliche Schaltungen mit dieser Funktionalität von der Erfindung umfaßt sind.

## Patentansprüche

1. Schaltungsanordnung zur Steuerung von zwei unabhängigen, mit einer gleichgerichteten Wechselspannung betreibbaren Lasten (2, 3) mit
einer Steuereinheit (11) zur Erzeugung eines Ansteuersignals für einen Halbleiterschalter (14; 24), durch den die beiden Lasten (2, 3) steuerbar sind in Abhängigkeit von je einem Steuersignal (17, 18) pro Last,
wobei die Steuereinheit (11) eine Phasenerkennungsvorrichtung (6) aufweist, durch die eine positive oder negative Phase der Wechselspannung erkennbar ist und die ein die momentane Phase beschreibendes Ausgangssignal (16) bereitstellt, und
wobei die Steuereinheit (11) eine Logikeinheit (19) aufweist zur Verknüpfung der Steuersignale (17, 18) mit dem Ausgangssignal (16) der Phasenerkennungsvorrichtung (6) zur Bestimmung des Ansteuersignals.

2. Schaltungsanordnung nach Anspruch 1,
**dadurch gekennzeichnet, daß**
zur Erzeugung zumindest eines Steuersignals (17) eine Zeitsteuerung (7) vorgesehen ist.

3. Schaltungsanordnung nach Anspruch 1 oder 2, **dadurch gekennzeichnet , daß** zur Erzeugung zumindest eines Steuersignals (18) eine Sensorschaltung (8) vorgesehen ist.

4. Schaltungsanordnung nach einem der Ansprüche 1 bis 3,
**dadurch gekennzeichnet, daß**
die Logikeinheit ein Multiplexer ist.

5. Schaltungsanordnung nach einem der Ansprüche 1 bis 4, **dadurch gekennzeichnet, daß** die Schaltungsanordnung ein integrierter Schaltungsbaustein ist.

6. Elektrisches Gerät mit einem Eingang (20) mit zwei Anschlüssen für eine Wechselspannung,
- einer Schaltungsanordnung (11) nach einem der Ansprüche 1 bis 5 und
- einem Gleichrichter (D11 .. D14), der mit dem Wechselspannungseingang (20) verbunden ist, und der eine gleichgerichtete Spannung bereitstellt zur Versorgung der Lasten (2, 3) und der Schaltungsanordnung (11) zur Steuerung der Lasten (2, 3), wobei der Gleichrichter (D11 .. D14) in einer offenen Brückenschaltung ausgeführt ist, bei der ein gemeinsamer Gleichspannungsausgang (21) mit einem ersten Lastanschluß des Halbleiterschalters (14; 24) verbunden ist und die offenen Gleichspannungsausgänge (22, 23) je auf einen Anschluß einer Last (2, 3) geführt sind, deren jeweils anderer Anschluß mit dem zweiten Lastanschluß des Halbleiterschalters (14; 24) verbunden ist.

## Claims

1. Circuit arrangement for controlling two independent loads (2, 3) that can be operated with a rectified AC voltage, having
a control unit (11) for generating a drive signal for a semiconductor switch (14; 24) which can be used to control the two loads (2, 3) on the basis of a respective control signal (17, 18) for each load,
the control unit (11) having a phase detection apparatus (6) which can be used to detect a positive or negative phase of the AC voltage and provides an output signal (16) which describes the instantaneous phase, and
the control unit (11) having a logic unit (19) for combining the control signals (17, 18) with the output signal (16) from the phase detection apparatus (6) in order to determine the drive signal.

2. Circuit arrangement according to Claim 1,
**characterized in that** a time controller (7) is provided for the purpose of generating at least one control signal (17).

3. Circuit arrangement according to Claim 1 or 2, **characterized in that** a sensor circuit (8) is provided for the purpose of generating at least one control signal (18).

4. Circuit arrangement according to one of Claims 1 to 3, **characterized in that** the logic unit is a multiplexer.

5. Circuit arrangement according to one of Claims 1 to 4, **characterized in that** the circuit arrangement is an integrated circuit module.

6. Electrical device having an input (20) with two connections for an AC voltage,
- having a circuit arrangement (11) according to one of Claims 1 to 5, and
- having a rectifier (D11 .. D14) which is connected to the AC voltage input (20) and provides a rectified voltage for supplying the loads (2, 3) and the circuit arrangement (11) for controlling the loads (2, 3), the rectifier (D11 .. D14) being in the form of an open bridge circuit in which a common DC voltage output (21) is connected to a first load connection of the semiconductor switch (14; 24) and the open DC voltage outputs (22, 23) are each connected to a connection of a load (2, 3), the respective other connection of which is connected to the second load connection of the semiconductor switch (14; 24).

## Revendications

1. Agencement de circuit pour la commande de deux charges (2, 3) indépendantes utilisables avec une tension alternative redressée, avec
une unité de commande (11) pour la génération d'un signal de commande d'amorçage pour un interrupteur à semiconducteurs (14; 24), par lequel les deux charges (2, 3) sont commandables en fonction d'un signal de commande d'amorçage (17, 18) par charge,
sachant que l'unité de commande (11) comporte un dispositif de détection de phase (6), grâce auquel une phase positive ou négative de la tension alternative est détectable et qui fournit un signal de sortie (16) décrivant la phase actuelle, et
sachant que l'unité de commande (11) comporte une unité logique (19) pour la mise en relation des signaux de commande (17, 18) avec le signal de sortie (16) du dispositif de détection de phase (6) pour la détermination du signal de commande d'amorçage.

2. Agencement de circuit selon la revendication 1, **caractérisé en ce qu'**une commande temporisée (7) est prévue pour la génération d'au moins un signal de commande (17).

3. Agencement de circuit selon l'une quelconque des revendications 1 ou 2, **caractérisé en ce qu'**un couplage de capteur (8) est prévue pour la génération d'au moins un signal de commande (18).

4. Agencement de circuit selon l'une quelconque des revendications 1 à 3, **caractérisé en ce que** l'unité logique est un multiplexeur.

5. Agencement de circuit selon l'une quelconque des revendications 1 à 4, **caractérisé en ce que** l'agencement de circuit est un module de circuit intégré.

6. Appareil électrique avec une entrée (20) avec deux raccords pour une tension alternative,
- un agencement de circuit (11) selon l'une quelconque des revendications 1 à 5, et
- un redresseur (D11 .. D14), lequel est relié à l'entrée de tension alternative (20) et fournit une tension redressée pour l'alimentation des charges (2, 3) et de l'agencement de circuit (11) en vue de la commande des charges (2, 3), sachant que le redresseur (D11 .. D14) est réalisé dans un couplage en pont ouvert, dans lequel une sortie commune (21) de tension continue est reliée à un premier raccord de charge de interrupteur à semiconducteurs (14; 24), les sorties de tension continue (23, 23) ouvertes étant couplées respectivement avec un raccord d'une charge (2, 3), dont l'autre raccord est relié respectivement avec le deuxième raccord de charge de l'interrupteur à semiconducteurs (14; 24).
